## Europäisches Patentamt

## European Patent Office

## Office européen des brevets

(19)

(11) Veröffentlichungsnummer: **0 238 915 B1**

(12) **EUROPÄISCHE PATENTSCHRIFT**

(45) Veröffentlichungstag der Patentschrift: **29.01.92**

(51) Int. Cl.⁵: **H05K 1/14**, H05K 1/18, H05K 7/10

(21) Anmeldenummer: **87103231.4**

(22) Anmeldetag: **06.03.87**

(54) **Verbindungs- und Schaltungsanordnung.**

(30) Priorität: **11.03.86 CH 982/86**

(43) Veröffentlichungstag der Anmeldung:
**30.09.87 Patentblatt 87/40**

(45) Bekanntmachung des Hinweises auf die
Patenterteilung:
**29.01.92 Patentblatt 92/05**

(84) Benannte Vertragsstaaten:
**CH DE FR GB IT LI NL SE**

(56) Entgegenhaltungen:
**EP-A- 0 066 706**
**DE-A- 1 947 399**
**US-A- 3 588 615**
**US-A- 4 225 900**
**US-A- 4 255 003**

(73) Patentinhaber: **Dyconex AG**
**Schaffhauserstrasse 580**
**CH-8052 Zürich(CH)**

(72) Erfinder: **Schmidt, Walter, Dr.**
**Oberwiesenstrasse 73f**
**CH-8050 Zürich(CH)**

(74) Vertreter: **Hunziker, Kurt**
**c/o Werkzeugmaschinenfabrik Oerlikon-**
**Bührle AG Patentbüro Birchstrasse 155**
**CH-8050 Zürich(CH)**

# Beschreibung

Die Erfindung bezieht sich auf eine mehrschichtige Verbindungs- und Schaltungsanordnung mit integrierten Halbleiter- und Hybridbauelementen.

Die fortschreitende, technische Entwicklung derartiger, mit mehreren Integrationsebenen versehenen Schaltungsanordnungen wie z.B. bekannt aus US-A-3 583 615 hat zu einer stets anwachsenden Zahl von elektronischen Funktionen bei gleichzeitiger Forderung der Raumbegrenzung geführt, wobei die relativ komplexen Schaltungsanordnungen bekanntlich einen entsprechend hohen technischen Fertigungs-Aufwand haben, wodurch eventuell erforderliche Funktions-Prüfungen aufgrund der Komplexität verhältnismässig aufwendig sind. Auch nachträgliche Aenderungen können nur mit grossem technischen Aufwand durchgeführt werden, so dass oftmals auch Neukonstruktionen erforderlich sind. Ausserdem führt die Forderung der relativ hohen Packungs- und Leistungsdichte zu einer unerwünschten hohen Wärmeentwicklung, welche bei Temperatur-Wechselbeanspruchungen Risse an den Lötstellen zur Folge hat.

Der Erfindung liegt die Aufgabe zugrunde, eine Schaltungsanordnung mit hoher Packungsdichte bei grösster Zuverlässigkeit zu finden, die die genannten Nachteile vermeidet oder wesentlich verringert, und welche mit geringem Entwicklungsaufwand herstellbar ist sowie einen geringen Prüfungsaufwand erfordert.

Diese Aufgabe wird erfindungsgemäss durch die Merkmale im Patentanspruch 1 gelöst.

Ausführungsbeispiele der Erfindung sind in der Zeichnung dargestellt und werden in folgenden näher beschrieben. Die Einzelheiten der Figuren geben wesentliche Merkmale der Erfindung wieder. Es zeigt:

Fig. 1    eine schematisch und perspektivisch dargestellte Leiterplatte mit matrixartiger Anordnung von einzelnen Modulen;

Fig. 2    ein schematisch und in Schnittansicht dargestelltes Modul;

Fig. 3    einen im Schnitt dargestellten Ausschnitt der Schaltungsplatte gemäss Fig. 1 mit beidseitig angeordneten Modulen;

Fig. 4    ein perspektivisch dargestelltes Modul, und

Fig. 5    ein in Schnittansicht dargestelltes, modulares Leiterplatten-System mit mehreren Modulen.

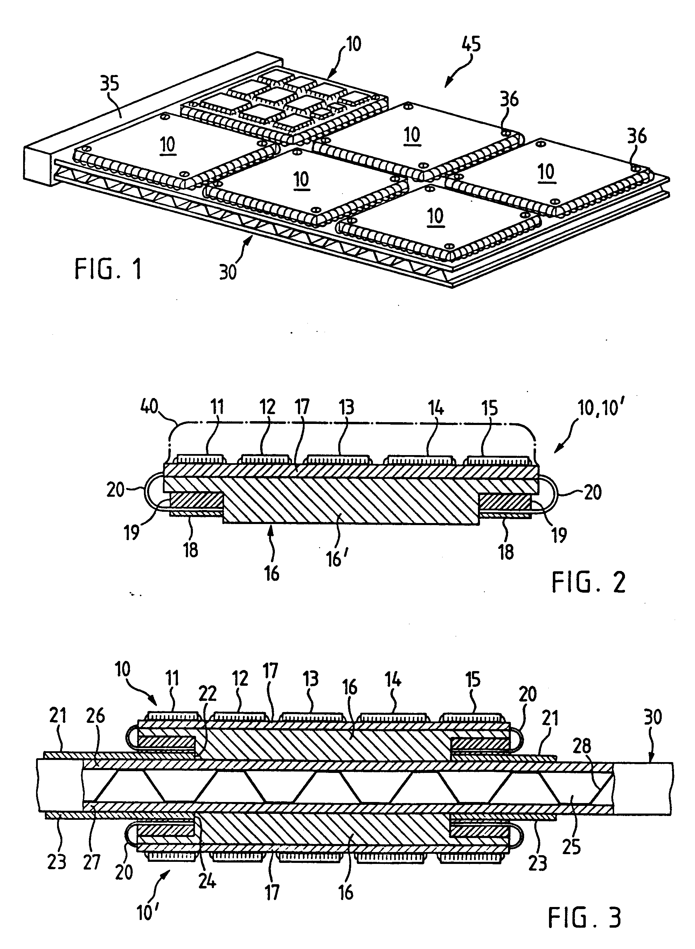

Fig.1 veranschaulicht als erstes Ausführungsbeispiel eine in der Gesamtheit mit 45 bezeichnete Leiterplatte mit stirnseitig befestigter Steckerleiste 35 und mit der matrixartigen Anordnung mehrerer Module 10, die im wesentlichen die gleichen Abmessungen mit vorzugsweise quadratischer Formgebung haben und mit Schrauben 36 oder anderen Befestigungsmitteln auf der einen Seite eines Trägerelements 30 lösbar befestigt sind, wobei an der anderen Seite des Trägerelements 30 ebenfalls Module (in Fig.1 nicht dargestellt) angeordnet sein können.

In Fig.2 ist in grösserem Massstab und in Schnittansicht das mit 10,10' bezeichnete und als eine Baueinheit ausgebildete Modul dargestellt, welches im wesentlichen eine metallische, mit einem abgesetzten Teilstück 16' ausgebildete Bodenplatte 16, eine flexible, vorzugsweise mehrlagige Leiterplatte 17 (Multilayer) sowie mehrere auf der Leiterplatte 17 matrixartig angeordnete passive und/oder aktive elektrische Komponenten 11,12,13,14 und 15 umfasst. Die flexible Leiterplatte 17 ist auf der Bodenplatte 16 auflaminiert, das heisst nach herkömmlichen Verfahren schichtverpresst. An dem abgesetzten Teilstück 16' der Bodenplatte 16 ist eine rahmenartige Zwischenlage 19 vorgesehen, welche als elastisches Pressglied dient und vorzugsweise aus elastomerem Werkstoff besteht.

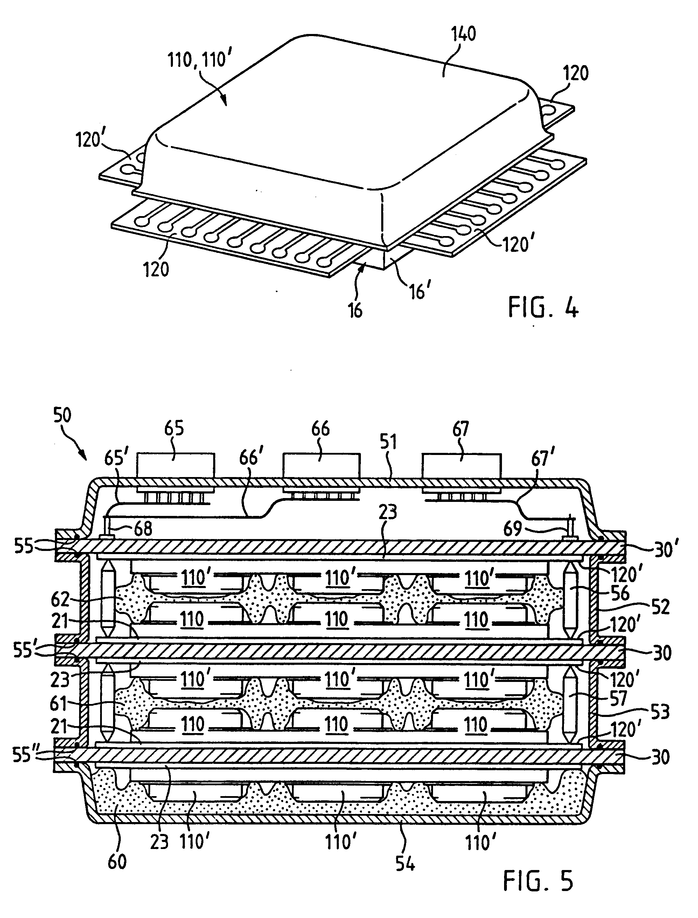

Weiterhin ist korrespondierend zu der Zwischenlage 19 ein Kontaktelement 18 vorgesehen, welches durch Anschlussleiter 20 mit der Leiterplatte 17 verbunden ist. Bei einer bevorzugten Ausführungsform sind die Anschlussleiter 20 flexible Enden (Fig. 4) der Leiterplatte 17, welche an mindestens zwei Seiten unter die Bodenplatte 16 gebogen und zwischen der Zwischenlage 19 und dem Kontaktelement 18 angeordnet sind. Das einzelne Modul 10,10' kann, wie in Fig.2 schematisch durch die strichpunktierte Linie dargestellt, durch eine entsprechend ausgebildete und die elektrischen Komponenten 11 bis 15 verschliessende Abdeckhaube 40 verschlossen werden.

Fig. 3 zeigt ein im Schnitt dargestelltes Teilstück des Trägerelements 30 mit beidseitig angeordneten Modulen 10,10'.

Das Trägerelement 30 besteht im wesentlichen aus einer ersten Platte 26 und einer zweiten Platte 27, welche Platten 26,27 durch entsprechend angeordnete Lamellen 28 derart im Abstand zueinander angeordnet und miteinander verbunden sind, dass für eine ausreichende Wärmeabfuhr zwischen den Platten 26,27 ein Hohlraum 25 gebildet wird.

Die Platten 26,27 des Trägerelements 30 sind jeweils mit auflaminierten Leiterplatten 21,23 vorzugsweise mehrlagigen Leiterplatten versehen, welche zur Aufnahme und thermischen Verbindung der Teilstücke 16' der Bodenplatte 16 mit den Platten 26,27 des Trägerelements 30 entsprechend ausgebildete Ausnehmungen 22,24 aufweisen. In zusammengebautem Zustand werden die jeweils mit dem abgesetzten Teilstück 16' in den Ausneh-

mungen 22,24 angeordneten Modulträger 10,10′ mittels der Schrauben 36 (Fig.1) gegen die Rückstellkraft der elastischen Zwischenlage 19 auf das Trägerelement 30 gepresst, wodurch einerseits die thermische Verbindung des Teilstücks 16′ mit der jeweiligen Platte 26,27 und andererseits eine elektrische Kontaktverbindung der Kontaktelemente 18 mit entsprechenden Gegenkontakten der Multilayer 21, 23 gewährleistet ist.

Als weiteres Ausführungsbeispiel ist in Fig.4 in perspektivischer Ansicht ein mit einer Abdeckhaube 140 versehenes Modul 110,110′ dargestellt, bei welchem, abweichend von dem Modul 10,10′ gemäss Fig.2, die mit 120,120' bezeichneten Anschlussleiter flächenartig ausgebildet und seitlich hervorstehend ausgebildet sind. Weiterhin erkennt man teilweise das Teilstück 16' der nur teilweise sichtbaren Bodenplatte 16.

Als weiteres Ausführungsbeispiel ist in Fig.5 ein multibles Leiterplatten-System 50 dargestellt, welches im wesentlichen zwei doppelseitig mit Modulen 110,110' bestückte Trägerelemente 30 sowie ein einseitig mit dem Modul 110' bestücktes Trägerelement 30' umfasst. Die Trägerelemente 30,30' sind vereinfacht dargestellt und durch Rahmenteile 52,53 im Abstand zueinander angeordnet und liegen mit ihren nicht näher bezeichneten Rändern jeweils auf den mit umlaufender Auflagefläche versehenen Rahmenteilen 52,53.

Das gehäuseartig geschlossene Leiterplatten-System 50 wird durch einen oberen Deckel 51 und einen unteren Deckel 54 verschlossen, wobei die Teile 51,52,53 und 54 mittels entsprechend angeordneter Dichtungen 55,55' und 55" gegeneinander abgedichtet sind durch nicht näher dargestellte Schrauben oder andere Befestigungsmittel eine Baueinheit bildend zusammengehalten werden.

Weiterhin erkennt man in Fig.5, dass die im Abstand zueinander angeordneten Trägerelemente 30,30' durch mehrere, die entsprechend ausgebildeten Anschlussflächen der Leiterplatten 23 und 21 kontaktiererde und vorzugsweise federnd ausgebildete elektrische Kontaktelemente 56,57 in Wirkverbindung stehen. Die zwischen den einzelnen Modulen 110,110' gebildeten, nicht bezeichneten Zwischenräume werden mit entsprechendem, jeweils ein sogenanntes Presskissen 60,61 und 62 bildenden Werkstoff ausgeschäumt.

An dem oberen Deckel 51 des Leiterplatten-Systems 50 sind im dargestellten Ausführungsbeispiel im Abstand zueinander angeordnete und schematisch dargestellte Steckerorgane 65,66 und 67 angeordnet und mittels Leitungen 65′,66′ und 67′ mit entsprechend am oberen Trägerelement 30′ vorgesehenen Kontaktelementen 68,69 verbunden.

An dieser Stelle sie darauf hingewiesen, dass die einzelnen Module 10,10′ und 110,110′ aufgrund ihrer einheitlichen, standartisierbaren Baugrösse kostengünstig herstellbar und hinsichtlich schaltungstechnischer Entwicklung, Fertigung, Prüfung und Zuverlässigkeit optimal festlegbar sind. Die erforderlichen Abmessungen der Module 10,10′; 110,110′ sind schaltungstechnisch gut übersehbar und gestatten ein einfaches, separates und funktionelles Prüfen des einzelnen Moduls.

Die erfindungsgemässe, mit den Modulen 10,10′ bestückte Leiterplatte 45 oder das mit den Modulen 110,110′ bestückte Leiterplatten-System 50 gewährleisten eine optimale Wärmeabführung. Die Wärmeenergie wird von den elektronischen Komponenten (Halbleiterbausteinen) 11,12,13,-14 und 15 über die Bodenplatte 16 auf das mit dem Hohlraum 25 versehene Trägerelement 30,30′ übertragen und dadurch eine zu Schäden führende örtliche Temperaturerhöhung weitgehend vermieden.

**Patentansprüche**

1. Mehrschichtige Verbindungs- und Schaltungsanordnung mit integrierten Halbleiter- und Hybridbauelementen, wobei,

   a) auf einer mehrlagigen Leiterplatte (17) mehrere, passive und/oder aktive elektrische Komponenten (11 bis 15) angeordnet und elektrisch mit der Leiterplatte (17) wirkverbunden sind,

   b) die mit den Komponenten (11 bis 15) versehene Leiterplatte (17) auf einer metallischen Bodenplatte (16) auflaminiert ist und die Komponenten (11 bis 15), die Leiterplatte (17) sowie die Bodenplatte (16) eine Modul-Baueinheit (10,10',110,110') bilden, und

   c) mehrere solcher Modul-Baueinheiten (10,10',110,110') auf einem Trägerelement (30), auf dem mindestens auf einer Seite eine weitere Leiterplatte (21) angeordnet ist, matrixartig angeordnet, mit der weiteren Leiterplatte (21) elektrisch verbunden und lösbar befestigt sind.

2. Verbindungs- und Schaltungsanordnung nach Anspruch 1, dadurch gekennzeichnet, dass das Trägerelement (30) mit beidseitig lösbar befestigten, matrixartig angeordneten Modulen (10,10') als Leiterplatten-Einheit (45) mit stirnseitig angeordneter Steckerleiste (35) ausgebildet ist.

3. Verbindungs- und Schaltungsanordnung nach Anspruch 1, gekennzeichnet durch eine multiple Bauweise mit mindestens zwei Trägerelementen (30,30'), die mit den übereinanderliegend, im Abstand zueinander angeordneten Modulen (110,110') in einem gehäuseartig verschlossenen Leiterplatten-System (50) angeordnet und elektrisch miteinander wirkverbunden sind.

4. Verbindungs- und Schaltungsanordnung nach Anspruch 3, dadurch gekennzeichnet, dass die zwischen den einzelnen Trägerelementen (30,30') mit ihren darauf angeordneten Modulen (110,110') gebildeten Zwischenräume mit einem als Presskissen (60,61) vorgesehenen Werkstoff ausgeschäumt sind.

5. Verbindungs- und Schaltungsanordnung nach Anspruch 1, dadurch gekennzeichnet, dass das Trägerelement (30,30') Bewandungen in Form metallischer Platten (25,27) aufweist und das einzelne Modul (10,10';110,110') mit der metallischen Bodenplatte (16) auf einer der metallischen Platten (26,27) angeordnet ist.

6. Verbindungs- und Schaltungsanordnung nach Anspruch 5, dadurch gekennzeichnet, dass zwischen der Platte (26,27) des Trägerelements (30) und der Bodenplatte (16) des Moduls (10,10';110,110') eine rahmenartige, elastische Zwischenlage (19) angeordnet ist.

7. Verbindungs- und Schaltungsanordnung nach einem der Ansprüche 1 bis 5, dadurch gekennzeichnet, dass von der Leiterplatte (17) des einzelnen Moduls (10,10';110,110') entsprechend weggeführte Anschlussleiter (20) unter den Rand der Bodenplatte (16) gebogen und zwischen einer Zwischenlage (19) und einem Kontaktelement (18) angeordnet sind.

8. Verbindungs- und Schaltungsanordnung nach einem der vorhergehenden Ansprüche 1-7, dadurch gekennzeichnet, dass das Trägerelement (30,30') zwei in parallelem Abstand zueinander angeordnete Platten (26,27) aufweist, zwischen welchen schräg zueinander angeordnete, an den Platten befestigte Lamellen (28) angeordnet sind.

9. Verbindungs- und Schaltungsanordnung nach einem der Ansprüche 1 oder 2, dadurch gekennzeichnet, dass in der auf dem Trägerelement (30,30') auflaminierten Leiterplatte (21,23) zur Aufnahme der Module (10,10';110,110') matrixartig angeordnete Ausnehmungen (22,24) vorgesehen sind.

10. Verbindungs- und Schaltungsanordnung nach Anspruch 3, dadurch gekennzeichnet, dass die Trägerelemente (30,30') durch elektrische Kontaktelemente (56,57) untereinander sowie durch Leitungen (65',66',67') mit am gehäuseartigen Verschluss (51) des Leiterplatten-Systems (50) angeordneten Steckerorganen (65,66,67) wirkverbunden sind.

## Claims

1. Multilayer connection and circuit arrangement with integrated semiconductor structural elements and hybrid structural elements, wherein
    a) several passive and/or active electrical components (11 to 15) are arranged on a multilayer printed circuit board (17) and are electrically operatively connected to the printed circuit board (17),
    b) the printed circuit board (17) provided with the components (11 to 15) is laminated on to a metallic base plate (16) and the components (11 to 15), the printed circuit board (17) as well as the base plate (16) form a modular structural unit (10,10',110,110'), and
    c) several such modular structural units (10,10' ,110,110') are arranged in a matrix-like manner on a carrier element (30), on which there is arranged on at least one side a further printed circuit board (21), are electrically connected to the further printed circuit board (21) and are releasably fastened.

2. Connection and circuit arrangement according to claim 1, characterized in that the carrier element (30) is constructed with modules (10,10') releasably fastened on both sides and arranged in matrix-like manner, as a printed-circuit-board unit (45) with a plug strip (35) arranged on the front side.

3. Connection and circuit arrangement according to claim 1, characterized by a multiple type of construction with at least two carrier elements (30,30'), which are arranged with the superjacent modules (110,110'), arranged at a distance to one another, in a printed-circuit-board system (50) closed in a housing-like manner and are electrically operatively connected to one another.

4. Connection and circuit arrangement according to claim 3, characterized in that the intermediate spaces formed between the individual carrier elements (30,30') with their modules (110,110') arranged thereon are foam-filled with a material provided as pressing cushion (60,61).

5. Connection and circuit arrangement according to claim 1, characterized in that the carrier element (30,30') has walls in the form of metallic plates (26,27) and the individual module (10,10';110,110') with the metallic base plate (16) is arranged on one of the metallic plates (26,27).

6. Connection and circuit arrangement according to claim 5, characterized in that between the plate (26,27) of the carrier element (30) and the base plate (16) of the module (10,10';110,110') there is arranged a frame-like, elastic intermediate layer (19).

7. Connection and circuit arrangement according to one of claims 1 to 5, characterized in that from the printed circuit board (17) of the individual module (10,10';110,110') connection leads (20), which are correspondingly led away, are bent under the edge of the base plate (16) and are arranged between an intermediate layer (19) and a contact element (18).

8. Connection and circuit arrangement according to one of the preceding claims 1-7, characterized in that the carrier element (30,30') has two plates (26,27) arranged at a parallel distance to one another, between which there are arranged fins (28) arranged inclined to one another and fastened to the plates.

9. Connection and circuit arrangement according to one of claims 1 or 2, characterized in that in the printed circuit board (21,23) laminated on to the carrier element (30,30') there are provided recesses (22,24), arranged in a matrix-like manner, for mounting the modules (10,10';110,110').

10. Connection and circuit arrangement according to claim 3, characterized in that the carrier elements (30,30') are operatively connected by electrical contact elements (56,57) to one another as well as by leads (65',66',67') to plug parts (65,66,67) arranged on the housing-like closure (51) of the printed-circuit-board system (50).

**Revendications**

1. Ensemble de connexion et de circuit à plusieurs couches comportant des éléments semiconducteurs intégrés et composants hybrides, ensemble selon lequel :

   a) une plaque de circuit imprimé (17) à plusieurs couches est munie de plusieurs composants électriques passifs et/ou actifs (11-15) et est reliée à la plaque de circuit imprimé (17),

   b) la plaque de circuit imprimé (17) munie des composants (11-15) est laminée sur une plaque de fond métallique (16) et les composants (11-15), la plaque de circuit imprimé (17) ainsi que la plaque de fond (16) forment un ensemble constructif modulaire (10, 10', 110, 110') et

   c) plusieurs tels ensembles modulaires à composants (10, 10', 110, 110') sont prévus sur un élément de support (30), sur au moins une face d'une autre plaque de circuit imprimé (21), suivant une répartition en matrice, en étant reliés électriquement et de manière amovible à l'autre plaque de circuit imprimé (21).

2. Ensemble de connexion et de circuit selon la revendication 1, caractérisé en ce que l'élément de support (30) est muni de modules (10, 10') fixés de manière amovible sur les deux faces suivant une répartition en matrice comme ensemble de plaques à circuit imprimé (45) dont la face frontale comporte une barrette de connexion (35).

3. Ensemble de connexion et de circuit selon la revendication 1, caractérisé par une construction multiple avec au moins deux éléments de support (30, 30') qui sont munis de modules (110, 110') superposés à une certaine distance dans un système de plaques de circuit imprimé (50) encapsulé par un boîtier avec des liaisons électriques.

4. Ensemble de connexion et de circuit selon la revendication 3, caractérisé en ce que les intervalles formés entre les différents éléments de support (30, 30') et les modules (110, 110') qu'ils portent sont remplis d'une mousse formant des coussins pressés (60, 61).

5. Ensemble de connexion et de circuit selon la revendication 1, caractérisé en ce que l'élément de support (30, 30') comporte des parois en forme de plaques métalliques (26, 27) et chaque module (10, 10', 110, 110') est prévu avec une plaque de fond métallique (16) sur l'une des plaques métalliques (26, 27).

6. Ensemble de connexion et de circuit selon la revendication 5, caractérisé en ce qu'entre la plaque (26, 27) de l'élément de support (30) et la plaque de fond (16) du module (10, 10' ; 110,, 110'), se trouve une couche intermédiaire (19) élastique formant un cadre.

7. Ensemble de connexion et de circuit selon l'une des revendications 1 à 5, caractérisé en ce que les conducteurs de raccordement (20) qui partent de la plaque de circuit imprimé (17) des différents modules (10, 10' ; 110, 110'), sont recourbés sous le bord de la plaque de fond (16) et viennent entre une couche intermédiaire (19) et un élément de contact (18).

8. Ensemble de connexion et de circuit selon l'une des revendications précédentes 1-7, caractérisé en ce que l'élément de support (30, 30') comporte deux plaques (26, 27) écartées, parallèles, entre lesquelles se trouvent des lamelles (28) disposées de manière inclinée et fixées aux plaques.

9. Ensemble de connexion et de circuit selon l'une des revendications 1 ou 2, caractérisé en ce que la plaque de circuit imprimé (21, 23) laminée sur l'élément de support (30, 30') comporte des cavités (22, 24) réparties suivant une matrice pour recevoir les modules (10, 10' ; 110, 110').

10. Ensemble de connexion et de circuit selon la revendication 3, caractérisé en ce que les éléments de support (30, 30') sont reliés par des éléments de contact électriques (56, 57) ainsi que par des conducteurs (65', 66', 67') avec un moyen de fermeture (51) en forme de boîtier pour l'ensemble du système des plaques de circuit imprimé (50) et des organes d'enfichage (65, 66, 67) prévus sur le moyen de fermeture.

FIG. 1

FIG. 2

FIG. 3

FIG. 4

FIG. 5